Europäisches Patentamt

European Patent Office

Office européen des brevets

(11) Veröffentlichungsnummer : **0 051 749**
**B1**

(12) **EUROPÄISCHE PATENTSCHRIFT**

(45) Veröffentlichungstag der Patentschrift :
**13.06.84**

(21) Anmeldenummer : **81108016.7**

(22) Anmeldetag : **07.10.81**

(51) Int. Cl.³ : **H 01 H 13/70, H 05 K 3/12**

(54) **Tastatur.**

(30) Priorität : **06.11.80 DE 3041859**

(43) Veröffentlichungstag der Anmeldung :
**19.05.82 Patentblatt 82/20**

(45) Bekanntmachung des Hinweises auf die Patenterteilung : **13.06.84 Patentblatt 84/24**

(84) Benannte Vertragsstaaten :
**AT BE CH FR GB IT LI NL SE**

(56) Entgegenhaltungen :
**EP-A- 0 036 570**
**DE-A- 2 635 888**
**FR-A- 1 347 869**
**FR-A- 2 447 598**
**US-A- 3 163 588**
**US-A- 3 917 917**
**US-A- 4 194 105**

(73) Patentinhaber : **PREH, Elektrofeinmechanische Werke Jakob Preh Nachf. GmbH & Co.**
**Postfach 1740 Schweinfurter Strasse 5**
**D-8740 Bad Neustadt/Saale (DE)**

(72) Erfinder : **Oelsch, Jürgen, Dipl.-Ing.**
**Sudetenstrasse 11**
**D-8741 Salz (DE)**

## Beschreibung

Die Erfindung geht von einer Tastatur nach dem Oberbegriff des Anspruches 1 aus. Eine derartige Tastatur ist aus der FR-A-2 447 598 bekannt. Die Tastatur weist eine Vielzahl von Drucktasten auf mit jeweils einem elastisch deformierbaren Schnappelement, bei dem sich ein Kontaktelement mit Abstand über einer Kontaktfläche befindet. Durch Deformation bei Betätigung des Schnappelementes wird das Kontaktelement mit der Kontaktfläche in Berührung gebracht. Kontaktflächen und/oder Kontaktelemente aus einer elektrisch leitfähigen Masse sind auf eine flexible Isolierfolie aufgedruckt. Ebenfalls auf die Isolierfolie aufgebracht sind beidseitig Leiterbahnen.

Bedingt durch den allgemeinen Trend von der Analog- zur Digitaltechnik werden in zunehmenden Maße Drucktastenschalter, einzeln oder in Tastaturen zusammengefaßt, in Geräten der Elektrotechnik allgemein, der Nachrichtentechnik und insbesondere in sogenannten Terminals oder Dateneingabevorrichtungen eingesetzt. Es gibt eine ganze Reihe von verschiedenen Bauarten und Funktionsprinzipien für derartige Tastaturen, die die Schnittstelle zwischen Mensch und Maschine darstellen. Von großer Bedeutung für die Zuverlässigkeit, aber auch für den Kontakt Mensch-Tastatur, ist die Art des Hubes. Neben den sogenannten Flachtastaturen mit einem Hub bis ca. 1,5 mm gibt es auch je nach Anwendungsbereich Tastaturen mit einem Hub zwischen 1,5 und 6,35 mm. Daneben werden natürlich auch Tastaturen mit Berührungsschaltern verwendet. Allen Tastaturen mit Hub ist jedoch gemeinsam, daß die Bedienperson über das Gefühl eine Art Rückkopplung erhalten sollte, daß die jeweilige Drucktaste betätigt worden ist.

In der US-A-3 163 588 und in der FR-A-1 347 869 sind gedruckte Schaltungen beschrieben, die beidseitig Leiterbahnen besitzen. Die elektrische Verbindung erfolgt durch sogenannte Durchkontaktierungen. Diese Durchkontaktierungen werden in Form von Bohrungen oder Lochungen hergestellt, deren Wandungen stromlos oder galvanisch metallisiert werden. Es wurde auch schon versucht, die elektrisch leitenden Verbindungen über das beidseitig metallkaschierte Kernmaterial der Löcher und ein Lot herzustellen (DE-A-18 14 805).

Durchkontaktierungen besitzt auch die gedruckte Schaltung, die in der US-A-4 194 105 beschrieben ist. Ferner sind Kontaktflächen und Leiterbahnen vorhanden. Die gedruckte Schaltung ist Bestandteil einer Tastatur, die unter anderem auch deformierbare Schnappelemente aufweist.

Aufgabe der vorliegenden Erfindung ist es, eine Tastatur nach der eingangs genannten Art zu schaffen, bei der auf möglichst einfache und daher kostengünstige Weise unter Ausnutzung beider Seiten Durchkontaktierungen in flexiblen gedruckten Folienschaltungen hergestellt werden.

Diese Aufgabe wird erfindungsgemäß durch die im kennzeichnenden Teil des Anspruches 1 angegebenen Merkmale gelöst.

Weitere vorteilhafte Ausgestaltungen der Erfindung sind den Unteransprüchen zu entnehmen.

Die Erfindung wird nachfolgend für mehrere Ausführungsbeispiele anhand der Zeichnungen näher beschrieben.

Von den Figuren zeigt

Figur 1 einen Schnitt durch eine Tastatur,

Figur 2 einen Schnitt durch eine andere Tastatur,

Figur 3 einen Schnitt durch eine weitere Tastatur,

Figur 4 a, b und c eine vergrößerte Darstellung von Durchkontaktierungen in einer flexiblen gedruckten Folienschaltung mit verschiedenen Durchmessern,

Figur 5 in perspektivischer Darstellung ein Teilstück einer flexiblen gedruckten Folienschaltung,

Figur 6 in perspektivischer Darstellung ein Teilstück einer anderen flexiblen gedruckten Folienschaltung.

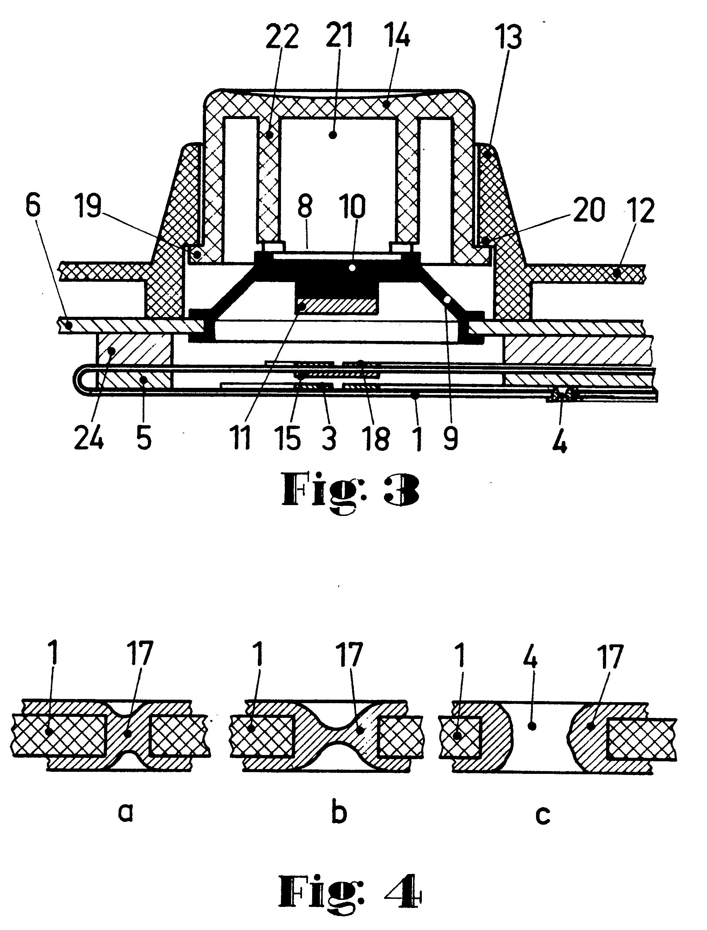

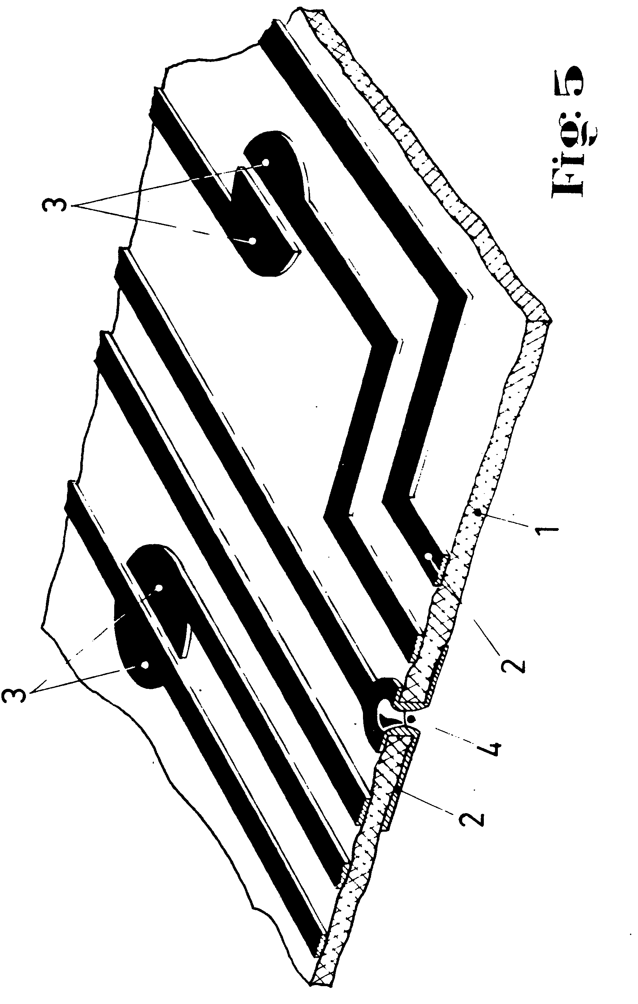

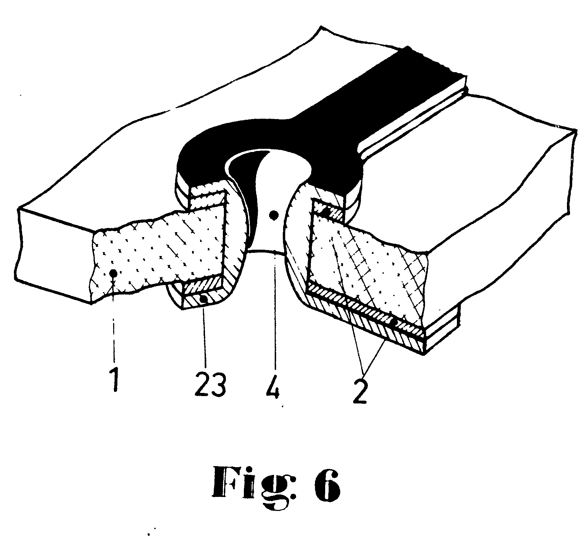

Mit 1 ist in den Figuren eine Isolierfolie einer flexiblen gedruckten Folienschaltung bezeichnet, auf der in Siebdrucktechnik in gewünschten Mustern Leiterbahnen 2 und erste Kontaktflächen 3 aufgebracht sind. Die Herstellung der Folienschaltung erfolgt derart, daß zunächst in der Isolierfolie 1, die eine Stärke bis maximal 0,6 mm haben kann, Lochungen 4 vorgenommen werden und zwar überall da, wo später Durchkontaktierungen vorhanden sein sollen. Danach werden auf einer Seite die Leiterbahnen 2 und die ersten Kontaktflächen 3 mit einer siebdruckfähigen Masse 17 aufgebracht. Hierbei ergibt es sich fast von selbst, daß die Masse auch in die Lochungen hineinfließt. Da die Isolierfolie nur maximal 0,6 mm stark sein soll, wird so zumindest auch der Rand der Lochungen von der Masse benetzt. Nach dem ersten Druckvorgang erfolgt eine Aushärtung. Anschließend wird die Isolierfolie gewendet und es erfolgt der zweite Druckvorgang mit dem Drucken der Leiterbahnen auf der Unterseite der Isolierfolie. Auch hier fließt wieder von der Masse etwas in die Lochungen, so daß durch den doppelten Druckvorgang eine sichere und verblüffend einfache Durchkontaktierung erreicht wird. Wie aus Figur 4 a, b oder c hervorgeht, hängt es unter anderem von dem Durchmesser der Lochungen ab, ob die Lochungen nur im Randbereich oder teilweise oder ganz mit der Masse ausgefüllt sind. Nach diesem zweiten Druckvorgang erfolgt eine erneute abschließende Aushärtung.

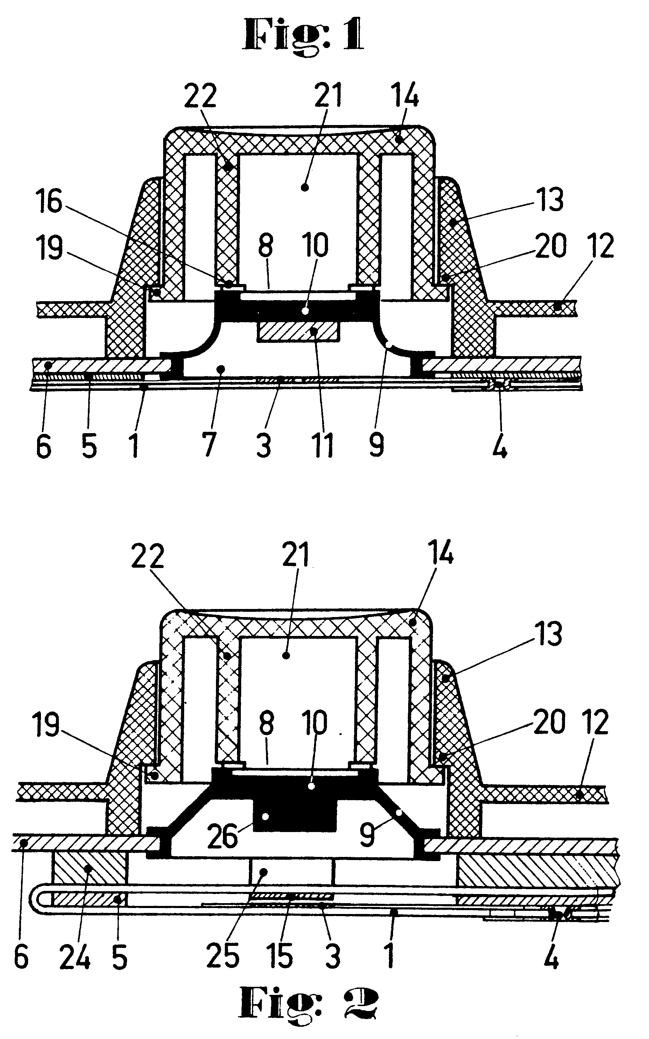

Über der mit Leiterbahnen und ersten Kontaktflächen versehenen Isolierfolie 1 befindet sich eine Isolierfolie oder Isolierplatte 5, die an den Stellen, an denen sich die ersten Kontaktflächen 3 befinden, ausgespart oder freigeschnitten ist. Auf dieser Isolierfolie oder Isolierplatte 5 liegt ein Metallrahmen 6, der eine der Anzahl der Betätigungsknöpfe entsprechende Zahl von Öffnungen 7 besitzt. In diesen Öffnungen ist ein vorzugsweise rundes Schnappelement 8 gehalten. Dieses Schnappelement ist aus einem gummielastischen Werkstoff, insbesondere Silikonkautschuk, hergestellt und es besitzt, wie aus den Figuren hervorgeht, einen bogenförmigen Randteil 9, der konkav oder konvex gewölbt ist (Figur 1) oder der auch kegelstumpfförmig ausgebildet sein kann (Figur 2 und 3), und einen im wesentlichen ebenen Oberteil 10. Die Funktionsweise entspricht dem Knackfroschprinzip. Bei der Herstellung werden nun in den Metallrahmen 6 in einem Arbeitsgang sämtliche Schnappelemente eingespritzt. Die Einspritzung der Schnappelemente erfolgt so, daß die Öffnungen 7 durch die Schnappelemente ganz verschlossen bzw. abgedichtet werden. Flexible Folienschaltung, Isolierfolie 5 und Metallrahmen 6 werden zumindest teilweise flächig verklebt. Dadurch wird erreicht, daß die Kontaktflächen vor störenden Umwelteinflüssen besser geschützt sind.

Auf der Unterseite des Schnappelementes 8 ist ein erstes Kontaktelement 11 vorhanden, das aus einem elektrisch leitenden Werkstoff, vorzugsweise einem elektrisch leitenden Silikonkautschuk, hergestellt ist und das, wenn das Schnappelement gedrückt ist, eine elektrische Verbindung zwischen der ersten Kontaktflächen 3 herstellen soll. Dieses Kontaktelement kann vorkonfektioniert und z. B. durch Stanzen hergestellt sein. Es kann vor dem Spritzen in die Form in hierfür vorgesehene Vertiefungen eingebracht werden und durch einen Vulkanisationsprozeß mit dem nachträglich eingespritzten Silikonkautschuk verbunden sein oder auch durch anschließendes Verkleben mit dem Schnappelement. Darüberhinaus ist die Herstellung und Einbringung des elektrisch leitenden Kontaktelementes nach dem Prinzip des Zweifarbenspritzens denkbar.

Über dem Metallrahmen 6 ist eine Abdeckplatte 12 angeordnet, die aus Metall oder Kunststoff hergestellt sein kann. Sie besitzt mehrere in den Figuren nicht dargestellte, seitlich etwa im rechten abgewinkelte Haltebeine, die durch die flexible gedruckte Folienschaltung und gegebenenfalls durch den Metallrahmen 6 und die Isolierplatte 5 ragen und deren aus der flexiblen gedruckten Folienschaltung herausragenden Enden verschränkt bzw. thermoplastisch verschweißt oder anderweitig festgelegt sind. Die Abdeckplatte 12 weist eine der Zahl der Drucktasten entsprechende Anzahl von hülsenförmigen Halterungen 13 aus Kunststoff auf, die in die Abdeckplatte eingespritzt oder eingeschnappt sind. Für den Fall, daß die Abdeckplatte aus Kunststoff besteht, können Halterungen 13 und Abdeckplatte einstückig hergestellt sein.

Jede Halterung dient zur Führung für einen Betätigungsknopf 14. Auf der Oberseite kann der Betätigungsknopf mit Zeichensymbolen versehen sein. Einseitig ist an den Betätigungsknopf ein seitlicher Ansatz 19 angeformt, der sich an einem Vorsprung 20 der Halterung abstützt und der ganz oder teilweise umfangseitig verläuft. Damit ist der Betätigungsknopf gegen ein Herausfallen gesichert. Im Innern des Betätigungsknopfes ist ein Hohlraum 21 vorhanden, in den eine hülsenförmige Wand 22 ragt. Mit dem stirnseitigen Rand dieser Wand liegt der Betätigungsknopf auf dem Schnappelement auf. Der stirnseitige Rand ist an einigen Stellen am Umfang durch kleine Aussparungen 16 unterbrochen, um einen Druckausgleich zu gewährleisten.

Der Rand der Öffnungen 7 im Metallrahmen kann glatt sein oder er kann im Randbereich eine umlaufende, beidseitige Anfasung besitzen, die von dem Randabschnitt des Schnappelementes umgriffen wird. Hierdurch wird eine Art Formschluß zwischen Metallrahmen und Schnappelement hergestellt, so daß die entstehenden Kräfte über diese mechanische Verankerung abgestützt werden, wodurch eine Vorbehandlung des Metalls mit einem Haftvermittler entfallen kann.

Ein weiteres Ausführungsbeispiel einer Tastatur ist in Figur 2 dargestellt. Auf einer flexiblen gedruckten Folienschaltung sind auf einer Seite der Isolierfolie 1 erste Kontaktflächen 3, Leiterbahnen 2 und zweite Kontaktelemente 15 in Siebdrucktechnik aufgebracht. Auf der Rückseite sind nur Leiterbahnen vorhanden. Die Folienschaltung wird nun so gefaltet, daß die zweiten Kontaktelemente über den ersten Kontaktflächen zu liegen kommen. Der erforderliche Abstand wird durch die Isolierplatte 5 oder eine Isolierfolie erreicht. Zwischen dem Metallrahmen 6 und der gefalteten Isolierfolie wird eine Abstandsplatte 24 oder eine Abstandsfolie mit Durchbrüchen eingefügt.

Diese Durchbrüche sind durch Kanäle oder Nuten miteinander verbunden, um einen Druckausgleich gewährleisten zu können. Der übrige Aufbau entspricht dem der Ausführungsform nach Figur 1. Lediglich das erste Kontaktelement wurde durch eine vorstehende Erhebung 26 auf der Unterseite des Schnappelementes ersetzt, die mit dem Schnappelement einstückig aus dem gleichen Material hergestellt ist. Wird der Betätigungsknopf 14 niedergedrückt, so drückt die Erhebung 26 das zweite Kontaktelement 15 gegen die ersten Kontaktflächen 3 und elektrische Verbindung wird hergestellt.

Ein anderes Ausführungsbeispiel einer Tastatur ist in Figur 3 gezeigt. Auf einer Seite der flexiblen gedruckten Folienschaltung sind erste Kontaktflächen 3, Leiterbahnen 2 und zweite Kontaktelemente 15 in Siebdrucktechnik aufgebracht. Auf der Rückseite sind ebenfalls Leiterbahnen und zusätzlich zweite Kontaktflächen 18 aufgedruckt. Die gedruckte Folienschaltung 1 wird so gefaltet, daß erste und zweite Kontaktflächen und zweite Kontaktelemente übereinanderliegen. Ferner ist noch eine Isolierplatte 5 oder eine Isolierfolie und eine Abstandsplatte 24 vorhanden. Der übrige Aufbau entspricht dem der Figur 1, d. h. auch hier ist auf der Unterseite des Schnappelementes ein erstes Kontaktelement 11 vorhanden. Wird nun der Betätigungknopf gedrückt, so kontaktiert zunächst das erste Kontaktelement 11 die zweiten Kontaktflächen 18. Drückt man weiter, so kontaktiert schließlich auch das zweite Kontaktelement 15 die ersten Kontaktflächen 3. Man erhält so auf einfache Weise ein zeitlich nacheinander ablaufendes Schalten.

In Figur 5 ist in perspektivischer Ansicht ein Teilstück einer flexiblen gedruckten Folienschaltung dargestellt. Die ersten Kontaktflächen 3 sind hier halbkreisförmig dargestellt. Es ist denkbar, daß diese auch eine andere Form oder geometrische Anordnung aufweisen, wie z. B. eine kammartig ineinandergreifende Form.

Bei den bislang beschriebenen Ausführungsbeispielen bestehen die Leiterbahnen und die Kontaktflächen aus einer siebdruckfähigen, elektrisch gut leitfähigen Masse 17, wie z. B. einer niederohmigen Silbermasse. Figur 6 zeigt ein weiteres Ausführungsbeispiel, bei dem das Leiterbahnbild auf die flexible Folie zunächst als niederohmige Masse, wie z. B. Silbermasse, aufgebracht ist oder bei dem die Leiterbahnen aus einer Kupferschicht oder einer anderen elektrisch gut leitenden, metallischen wie z. B. Aluminium- oder Nickelschicht bestehen. Dies kann entweder in reiner Siebdrucktechnik geschehen oder die Herstellung der Leiterbahnen erfolgt in einem der bekannten Additiv-, Semiadditiv- oder Subtraktivverfahren. Auf diese erste Schicht wird nun eine zweite Schicht 23 aufgedruckt, die höherohmig ist und die die Eigenschaften einer Widerstandsschicht haben kann. Die Beschaffenheit dieser Schicht ist hierbei so, daß die Lochungen 4, genau wie in Figur 4 a, b und c dargestellt, ausgefüllt werden und damit auf einfachste Weise eine Durchkontaktierung ermöglicht wird.

Der Vorteil der höherohmigen Schicht liegt darin, daß insbesondere an den Kontaktflächen ein teueres Edelmetall durch diese relativ preiswerte Schicht ersetzt werden kann. Die Leitfähigkeit der Leiterbahnen wird im wesentlichen durch die niederohmige, als erste auf die flexible Folie aufgebrachte Schicht bestimmt. Außerdem ergibt sich als Vorteil, daß im gleichen Druckvorgang Widerstandsschichten zwischen den Leiterbahnen erzeugt werden können.

## Ansprüche

1. Tastatur mit mindestens einer flexiblen Isolierfolie (1), auf die beidseitig Leiterbahnen (2) und auf jeweils einer Seite Kontaktflächen (3, 18) und/oder Kontaktelemente (15) aus einer elektrisch leitfähigen Masse aufgedruckt sind, mit einer Vielzahl von den Kontaktflächen (3, 18) zugewandten, jeweils ein deformierbares Schnappelement (8) umfassenden Drucktasten, bei denen sich jeweils ein Kontaktelement (11, 15) mit Abstand über einer Kontaktfläche (3, 18) befindet, das durch Deformation des Schnappelementes (8) bei dessen Betätigung mit der Kontaktfläche (3, 18) in Berührung bringbar ist, dadurch gekennzeichnet, daß die Isolierfolie (1) nur maximal 0,6 mm stark ist, daß die beiden Folienseiten in getrennten Druckvorgängen jeweils von oben bedruckt sind, daß in der Isolierfolie (1) Lochungen (4) vorgesehen sind, die der elektrisch leitenden Verbindung von auf verschiedenen Seiten der Isolierfolie (1) liegenden, elektrisch leitenden Bereichen dienen, und daß die genannten leitenden Verbindungen durch bei den Druckvorgängen in die Lochungen (4) einfließende und dort aushärtende Anteile der die Druckflüssigkeit bildenden elektrisch leitfähigen Masse (17, 23) gebildet ist.

2. Tastatur nach Anspruch 1, dadurch gekennzeichnet, daß die Lochungen (4) über die Beschichtung der Lochwandungen hinaus zumindestens teilweise durch die elektrisch leitfähige Masse (17, 23) ausgefüllt sind.

3. Tastatur nach Anspruch 1, dadurch gekennzeichnet, daß die bedruckte Isolierfolie (1), eine über ihr liegende Isolierplatte (5) oder Isolierfolie und ein darüber liegender, eine Halterung für die Schnappelemente (8) bildender Metallrahmen (6) miteinander verklebt sind.

4. Tastatur nach Anspruch 1, dadurch gekennzeichnet, daß die Leiterbahnen (2) aus einer ersten Schicht mit einer elektrisch gut leitfähigen ersten Masse und einer zweiten Schicht (23) mit einer zweiten Masse bestehen, deren Leitfähigkeit geringer ist.

5. Tastatur nach Anspruch 4, dadurch gekennzeichnet, daß die erste Schicht eine Kupferschicht ist und die zweite Schicht aus einer Widerstandsmasse besteht.

6. Tastatur nach Anspruch 5, dadurch gekennzeichnet, daß die Lochungen (4) zur elektrisch leitenden Verbindung der beiden Folienseiten lediglich Widerstandsmasse enthalten.

## Claims

1. Keyboard having at least one flexible insulating film (1), on both of whose sides printed conductors (2), and on one of whose respective sides contact areas (3, 18) and/or contact elements (15) made of an electrically conductive substance are printed, having a plurality of push-buttons facing the contact areas (3, 18) and each enclosing a deformable snap-action element (8), in the case of which push-buttons one respective contact element (11, 15) is located in spaced arrangement above a contact area (3, 18) which contact element can be brought into contact with the contact area (3, 18) when the snap-action element (8) is operated and deforms, characterised in that the insulating film (1) has a maximum thickness of only 0.6 mm, in that the two sides of the film are printed in each case from above in separate printing operations, in that there are provided in the insulating film (1) apertures (4), which serve for the electrically conductive connection of electrically conductive areas located on different sides of the insulating film (1), and in that the said conductive connections are formed by parts of the electrically conductive substance (17, 23) forming the printing fluid, which parts flow into the apertures (4) in the event of printing operations and harden there.

2. Keyboard according to claim 1, characterised in that the apertures (4) are filled beyond the layering of the aperture walls at least partly by the electrically conductive substance (17, 23).

3. Keyboard according to claim 1, characterised in that the printed insulating film (1), an insulating film or insulating plate (5) located above it, and a metal frame (6) above that forming a means of support for the snap-action elements are bonded together.

4. Keyboard according to claim 1, characterised in that the printed conductors (2) consists of a first layer with a first substance which is a good electrical conductor and a second layer (23) with a second substance, which conducts less well.

5. Keyboard according to claim 4, characterised in that the first layer is a copper layer and the second layer consists of a resistive substance.

6. Keyboard according to claim 5, characterised in that the apertures (4) contain only resistive material for the purpose of the electrically conductive connection of the two sides of the film.

**Revendications**

1. Clavier comportant au moins une feuille isolante souple (1), sur les deux faces de laquelle sont imprimées des pistes conductrices (2) et sur l'une des faces respectives de laquelle sont imprimés des surfaces de contact (3, 18) et/ou des organes de contact (15) en une matière électriquement conductrice, comportant un grand nombre de boutons-poussoirs tournés vers les surfaces de contact (3, 18), entourant chacun un élément déformable à déclic (8) et parmi lesquels se trouve à chaque fois, à distance au-dessus d'une surface de contact (3, 18), un organe de contact (11, 15) qui, par une déformation de l'élément à déclic (8) lorsque ce dernier est actionné, peut être mis en contact avec la surface de contact (3, 18), clavier caractérisé par le fait que la feuille isolante (1) présente seulement une épaisseur de 0,6 mm au maximum ; par le fait que les deux faces de cette feuille sont respectivement imprimées de haut en bas par des processus d'impression individuels ; par le fait que, dans la feuille isolante (1), sont percés des trous (4) qui servent à assurer la liaison électriquement conductrice de zones électriquement conductrices situées sur différentes faces de la feuille isolante (1) ; et par le fait que les liaisons conductrices précitées sont formées par des quantités de la matière électriquement conductrice (17, 23) constituant le fluide sous pression, qui fluent dans les trous (4) lors des processus d'impression et durcissent dans lesdits trous.

2. Clavier selon la revendication 1, caractérisé par le fait que les trous (4) sont, au-delà du revêtement de leurs parois, comblés au moins partiellement par la matière électriquement conductrice (17, 23).

3. Clavier selon la revendication 1, caractérisé par le fait que la feuille isolante imprimée (1), une plaque isolante (5) ou une feuille isolante placée sur cette feuille, ainsi qu'un cadre métallique (6) sus-jacent et formant un support pour les éléments à déclic (8), sont solidarisés par collage.

4. Clavier selon la revendication 1, caractérisé par le fait que les pistes conductrices (2) consistent en une première couche comportant une première matière de bonne conductibilité électrique, ainsi qu'en une seconde couche (23) comportant une seconde matière dont la conductibilité est plus faible.

5. Clavier selon la revendication 4, caractérisé par le fait que la première couche est une couche de cuivre et la seconde couche consiste en une matière résistive.

6. Clavier selon la revendication 5, caractérisé par le fait que les trous (4) renferment seulement une matière résistive en vue d'une liaison électriquement conductrice entre les deux faces de la feuille.

# Fig. 1

# Fig. 2

1

**Fig: 3**

**Fig: 4**

Fig. 5

**Fig: 6**